# EUROPEAN PATENT SPECIFICATION

(11) **EP 0 682 373 B1**
(45) Date of publication and mention of the grant of the patent: **03.06.1998**
(21) Application number: 95650016.9
(22) Date of filing: 12.05.1995
(51) Int. Cl.: H01L 27/144, H01L 27/15

(54) **Optoelectronic integrated circuit**
Integrierte optoelektronische Schaltung
Circuit intégré optoélectronique

(30) Priority: 12.05.1994 IE 940389
(43) Date of publication of application: 15.11.1995
(73) Proprietor: HITACHI EUROPE LIMITED, Maidenhead, Berkshire, SL6 8YA (GB); The Provost Fellows and Scholars of the College of the Holy and Undivided Trinity of Queen Elizabeth Near Dublin, Dublin 2 (IE)
(72) Inventor: O'Sullivan, Garrett, Derry (IE); Hegarty, John, Dublin 2 (IE); Horan, Paul, Rathmines, Dublin 6 (IE)
(74) Representative: O'Connor, Donal Henry

(56) References cited:
- EP-A- 0 073 889
- EP-A- 0 323 074
- EP-A- 0 331 103
- EP-A- 0 387 416
- IEEE PHOTON. TECH. LETTS., vol. 4, no. 6, June 1992 pages 614-617, T.K. WOODWARD, ET AL. 'OPERATION OF A FULLY INTEGRATED GAAS-ALXGA1-XAS FET-SEED: A BASIC OPTICALLY ADDRESSED INTEGRATED CIRCUIT'

## Description

The invention relates to the monolithic integration of electronic devices with optical devices of the p-i-n type to form an optoelectronic integrated circuit.

More particularly, the invention relates to an optoelectronic integrated circuit comprising:-
a substrate;
an optical device in the form of a p-i-n mesa structure, and
an electronic device mounted transversely of the optical device in the direction of its p-i-n layers, and being fabricated in a lower one of the doped layers closest to the substrate of the optical device.

Such an integrated circuit is described in EP 331103 (Sumitomo). The devices are fabricated on an InP substrate and the optical device is a diode.

In this technology, the main challenge has been to incorporate transistor circuitry into the p-i-n structure such that operation of all devices is satisfactory and complex processing is not needed.

Several other such integrated circuits have heretofore been developed. For example, United States Patent Specification No. US 4,884,119 and the Paper "Field Effect Transistor Self-Electrooptic Effect Device: Integrated Photodiode, Quantum Well Modulator and Transistor" by D.A.B. Miller et al and published in IEEE Photonics Technology Letters, Vol 1, No. 3, March 1989 describes such a type of integrated circuit. The optical device is of the n-i-p type in which the n-layer is used for fabrication of the electronic circuit so that it therefore lies on top of the optical device. Windows are etched in the n-layers for the optical device operation. While such an optoelectronic device is apparently quite effective, because the electronic device transistors are mounted on the n-layer of the optical device, they become part of an n-i-p diode in which the p-layer extends under more than one n-channel transistor. For operation of the integrated circuit, the p-layer is held at a fixed voltage to facilitate operation of the optical device. As the potential of the channel in the field effect transistors of the electronic device rises, it reverse-biasses the diode. This depletes the channel electron population, which in turn limits the circuit's performance. There is also a problem of parasitic capacitance caused by presence of the continuous p-layer underneath the electronic device.

The paper B.F. Aull et al., "Monolithic optoelectronic transistor: A new smart-pixel device", Appl. Phys. Lett. 63 (11), September 1993 also describes an optoelectronic integrated circuit and the arrangement here is that n-layer FETs are mounted on the (top) p-layer of the p-(MQW)-n diode. This arrangement necessitates very deep etching between transistors, thereby making processing very difficult. Further, similar comments regarding backgating and speed problems apply to this integrated circuit as there is a continuous p-layer beneath the n-layer FET electronic devices.

The paper T.K. Woodward et al., "Operation of a Fully Integrated GaAs-AlGaAs FET_SEED: A basic optically addressed integrated circuit", IEEE Photon. Tech. Letts., 4(6), June 1992 also describes an optoelectronic integrated circuit. This circuit has a reflector stack, on top of which there is a conducting p-layer, and in turn there is a multiple quantum well region. On top of the multiple quantum well region is grown a series of layers in which a DMT (doped MISFET like transistor) is fabricated. In this arrangement, the problem of backgating is addressed by use of proton bombardment of selected areas of the underlying p-layer to create "islands" between the transistors. Such a process is described in the paper L.A. D'Asaro et al., "Batch Fabrication and testing of FET-SEED smart pixel arrays", as [2], paper no. TUC4, pp. 63-64. This is a complex and expensive process. Further it does not solve the problems of low speed caused by parasitic capacitance which arises because of the fact that there is a contacted conducting layer underneath the electronic device.

The invention is directed towards providing an improved optoelectronic integrated circuit in which electronic devices are incorporated without degrading the optical characteristics of the optical devices. Another object is that the circuit does not suffer from backgating or low speed problems, and that it has a relatively simple structure.

Another object of the invention is to provide a method for producing an optoelectronic integrated circuit, the method being relatively simple.

The invention is characterised in that,
the optical device is a modulator with the i-layer in the form of a MQW structure; and
the optical modulator and the electronic device are fabricated on an undoped reflector which is in turn fabricated on the substrate.

Accordingly, in a very simple arrangement, the situation whereby a conducting layer underlies the electronic device is avoided. Therefore, the problems of backgating and low speed switching are avoided.

This is an advantageous construction as the optical device bias may be easily applied outside of the reflector, thereby providing for fast switching speeds of the optical device.

Preferably, a lower doped optical modulator layer closest to the reflector comprises a plurality of sub-layers, said sub-layers comprising a plurality of lower sub-layers which are present in both the optical modulator and the electronic device, and an upper sub-layer which is present only in the optical modulator.

In one embodiment, the electronic device is fabricated in the n-layer of the optical modulator. This layer is particularly suitable for transistor fabrication.

In another embodiment, the electronic device is a field effect transistor.

In another embodiment, the electronic device comprises an undoped channel, whereby electrons experience relatively little scattering. Preferably, the electronic device is a high electron mobility transistor. This is particularly suitable for fabrication in the n-layer of the optical device as there is low additional absorption caused within the optical device at specific wavelengths.

In one embodiment, the reflector is of AlGaAs/AlAs composition.

Preferably, the optical modulator is of the vertically-propagating type.

According to another aspect, the invention provides a method of producing an optoelectronic integrated circuit comprising at least one optical modulator of the p-MQWi-n type and at least one electronic device in an integrated monolithic structure, the method comprising the steps of:-
growing an undoped reflector on a substrate;
growing optical modulator layers above the reflector;
etching the optical device layers at selected locations to expose the lower doped optical modulator layer closest to the substrate; and
fabricating an electronic device in said lower doped optical modulator layer.

In this way, an optoelectronic integrated circuit is produced which has operational advantages and the method involves use of conventional operations such as etching.

Preferably, the electronic device is fabricated in the n-layer of the optical modulator.

In one embodiment:-
the lower doped optical device layer is grown as a plurality of sub-layers; and
etching takes place to selectively expose some of said sub-layers to form the electronic device.

In this latter embodiment, some lower sub-layers may be relatively thin and be primarily for electronic use, and there may be an upper sub-layer which is primarily to facilitate fabrication.

This methodology provides for fabrication of the electronic device in the lower doped optical device layer in a simple manner, even where the electronic device is relatively complex. Indeed, one of the sub-layers may be undoped to provide for fabrication of an electronic device of the high electron mobility transistor type. This does not alter the fact that although the sub-layers may have differing doping concentrations, together they are regarded as forming the lower doped layer of the optical device.

The invention will be more clearly understood from the following description of some embodiments thereof, given by way of example only, with reference to the accompanying drawings, in which:-
Fig. 1 is a schematic cross-sectional representation of part of an optoelectronic integrated circuit of the invention; and
Fig. 2 is a perspective view illustrating interconnection of devices of the integrated circuit.

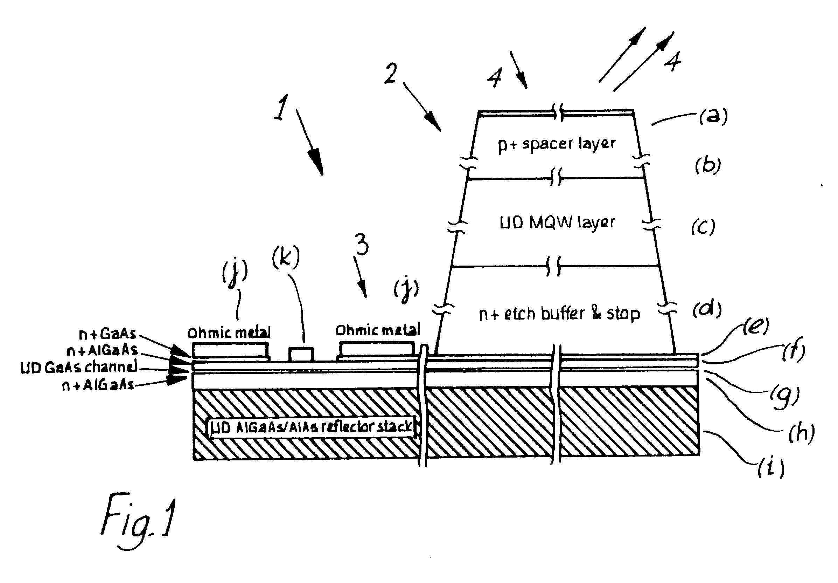

Referring to the drawings, there is shown an optoelectronic integrated circuit of the invention, indicated generally by the reference numeral 1. In Fig. 1, only part of the circuit 1 is shown so that its construction may be easily understood. The circuit 1 comprises an optical device 2 which in this embodiment is a p-i-n mesa structure and a reflector stack. This structure is formed by layers (a) to (i) inclusive, these layers being described in more detail below. The circuit 1 also comprises an electronic device 3, in this embodiment a quantum well - high electron mobility transistor (QW-HEMT). The electronic device 3 is mounted alongside the optical device 2 and is incorporated into the n-layer. The electronic device 3 comprises n+ layers (e), (f) and (h), an undoped channel (g) on each side of which there is a separation layer and various contacts (j) and gates (k) mounted on the layers (e) and (f). The electronic device 3 is mounted directly on the reflector stack (i), which is undoped. The electronic device layers (e), (f) and (h) are n-doped, layer (g) is undoped, and therefore those parts of the layers which extend underneath the optical device 2 form part of the optical device.

The following table outlines, in more detail, the composition of layers (a) to (i) of the circuit 1.

**TABLE**

| **Identifier** | **Description** | **Thickness & Composition** |
|---|---|---|
| (a) | Contact | 5nm 9E 18 Zn: GaAs |
| (b) | p+ spacer layer | 346nm 9E 18 Zn: A10.3 |
| (c) | UD MQW layer | 70 periods (6nm A10.3/9nm GaAs) + 1 x 6 nm A10.3 Eln @ 849 nm |
| (d) | n+etch buffer & stop | 20nm UD A10.1 130nm IE 18 Si: A10.1 10nm 5E 17 Si: AlAs |
| (e) | n+GaAs contact | 5nm 3E 18 Si: GaAs |
| (f) | n+AlGaAs | 35nm IE 18 Si: A10.3 |
| (g) | separation layer channel separation layer | 2.5nm UD A10.3 21nm UD GaAs 2.5nm UD A10.3 |
| (h) | n+ AlGaAs | 19nm IE 18 Si: A10.3 |
| (i) | spacer/mirror | 41nm UD A10.3 (spacer) 14.5 period DBR (72nm UD AlAs/ 61nm UD A10.1 (mirror) |
| Note: UD = Undoped | | |

The items (j) are ohmic metal contacts to form the source and drain of the HEMT transistors, items (k) being Schottky gates, and are formed during electronic circuit fabrication.

It will be noted that the layer (g) is an undoped channel for movement of electrons in the HEMT transistor. As the electrons move in the undoped channel (g) they experience relatively little scattering. The device 3 is therefore a low noise device suitable for low noise, high speed circuitry. Indeed, the HEMT may be regarded as a high speed transistor suitable for microwave circuitry. Further, it causes very little additional absorption at the operating wavelength in the optical device 2 because it has a very thin GaAs layer.

A major advantage arising from the structure of the circuit 1 is that there is no conducting layer underlying the electronic device 3. Accordingly, backgating and speed loss caused by a type of parasitic capacitance do not arise. This avoids the need for a complex and expensive proton bombardment process which has heretofore been required. Another advantage which will be immediately apparent is the fact that the electronic device 3 may be connected to the optical device 2 to provide bias voltages between the layers (e) and (a) and accordingly, charging and discharging of the relatively thick reflector stack (i) is avoided. This also provides for faster switching.

The manufacturing process for the structure 1 involves growing successively the layers beginning with the reflector stack (i) over the substrate (not shown). When all of the layers have been grown, standard electronic processing etching technology is used to remove the layers (a) to (d) inclusive to reveal the layer (e). Following this, the various gates, contacts and conducting interconnections are then made according to the circuit design. Although the circuit 1 is non-planar, it has been found that the step height of the optical device 2 is approximately 1.6 µm and is generally below 1.8 µm and accordingly conventional photolithographic techniques can be used.

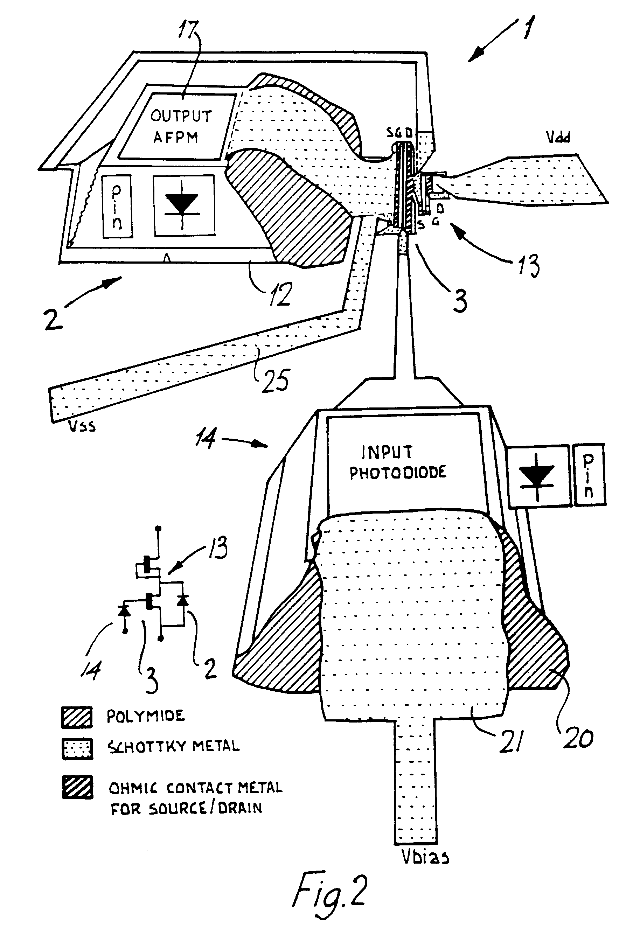

Referring now to Fig. 2, the full integrated circuit 1 is illustrated. The circuit diagram is shown alongside it. The circuit 1 comprises the optical device 2 functioning as an AFPM, the n-layers (d) to (h) of which are indicated by the numeral 12. The circuit 1 also comprises the HEMT transistor electronic device 3 and a second such device 13. Finally, the circuit 1 also comprises an optical device 14 operated as a photodiode. For clarity, in the following description, the optical device 2 is referred to as a "modulator" and the optical device 14 as a "photodiode".

The circuit 1 functions as an optoelectronic amplifier wherein light incident on the photodiode 14 generates a voltage which is amplified by the electronic devices 3 and 13. This provides a voltage which controls the response of the modulator 2. Thus, a low power beam can control a high power beam. In more detail, the modulator 2 is coated with a polyimide coating layer 15. This underlies a Schottky metal track 16 which connects a contact 17 of the modulator 2 to a source S of the electronic device 3. A polyimide layer 20 underlies a Schottky metal layer 21 in a similar manner on the photodiode 14 for connection of the p-contact of the photodiode 14 with a bias power supply V_{bias}. The n-contact of the photodiode 14 is connected to a gate G of the transistor 3. The source S of the transistor 3 is connected to a power supply terminal Vₛₛ by a track 25. The n-side of the modulator 2 is connected by a track to the drain D of the transistor 3 and to the source S of a narrow transistor 13. The drain D of the transistor 13 is connected to a drain voltage supply V_{dd}. In practice, the insulating polyimide coating would cover the entire structure, with selective windows where required.

In operation, the top of the AFPM modulator 2 has its voltage held at Vₛₛ while the bottom (the n-side) is connected to the drain of the transistor 3 and to the source of the transistor 13. Accordingly, the voltage across the modulator 2 is controlled by operation of the transistors 3 and 13 and the reflectivity of the modulator 2 is thereby controlled. The top of the photodiode 14 (p-side) is held at the voltage of V_{bias}. The bottom of the photodiode 14 (n-side) is connected to the gate of the transistor 3.

Assuming V_{bias} is held at about -1V, with no light incident, the voltage on the gate of the wide transistor is therefore -1V and it is switched off. Its drain voltage is therefore close to V_{dd}. Let us assume V_{dd} is about 10 V. When light enters the photodiode, the voltage on its n-side increases. This raises the voltage on the gate of the transistor 3, switching it on. Its drain voltage drops to close to Vₛₛ, which could be set at 0 volts. Accordingly, the voltage across the modulator 2 changes from about 10V (V_{dd} - Vₛₛ) to about 0V (Vₛₛ - Vₛₛ) and its reflectivity changes from about 3% to about 90% for vertically incident light.

It will be appreciated that the invention provides a quite complex integrated circuit without the necessity for a complex or expensive manufacturing process. Further, the integrated circuit operates at a high speed with very good output optical contrast ratios, and fast switching action. It will also be clear from the illustration of Fig. 2 that the top surfaces of the optical devices may be etched quite easily as desired to adjust parameters such as the optical resonance. This is a parameter which tends to vary over a fabricated wafer, thereby depressing yield. Tuning of the resonance is therefore an important consideration for large two-dimensional arrays of processing cells. Alternatively, it is possible to grow an additional front mirror to increase the contrast ratio of the output modulation and to lower the required number of quantum wells. A still further alternative is to coat the top surface with an anti-reflecting coating to destroy the optical cavity. This broadens the range of operation in terms of available wavelength and increases yield. It will be appreciated from the structure of the circuits 1 and 10 that these operations may be relatively easily carried out.

The invention is not limited to the embodiments hereinbefore described, but may be varied in construction and detail. For example, it is envisaged that an optical device of the type which does not have normally or vertically propagating light may be used. The electronic device is not necessarily a HEMT as any type of FET could be used if it may be incorporated into the lower of the n or p-layers of the optical device. While the electronic devices are fabricated from layers which are apparently distinct from the n-layer of the optical device, and may vary in concentration of dopant, they may still be regarded as part (or sub-layers) of the optical device's n-layer. The arrangement depends on design and production methodology and it is envisaged that the electronic devices may be formed from an integral doped layer of the optical device.

## Claims

1. A monolithic optoelectronic integrated circuit (1) comprising:-
a substrate;
an optical device (2) in the form of a p-i-n mesa structure; and
an electronic device (3) mounted transversely of the optical device in the direction of its p-i-n layers ((a)-(h)), and being fabricated in a lower one of the doped layers closest to the substrate ((d)-(h)) of the optical device, characterised in that:-
the optical device (2) is a modulator with the i-layer in the form of a MQW structure; and
the optical modulator (2) and the electronic device (3) are fabricated on an undoped reflector (i) which is in turn fabricated on the substrate.

2. An integrated circuit as claimed in claim 1, wherein a lower doped optical modulator layer closest to the reflector comprises a plurality of sub-layers (d-h), said sub-layers comprising a plurality of lower sub-layers which are present in both the optical modulator and the electronic device, and an upper sub-layer which is present only in the optical modulator.

3. An integrated circuit as claimed in any preceding claim, wherein the electronic device is fabricated in the n-layer ((d)-(h)) of the optical modulator.

4. An integrated circuit as claimed in any preceding claim, wherein the electronic device is a field effect transistor.

5. An integrated circuit as claimed in any preceding claim, wherein the electronic device comprises an undoped channel (g), whereby electrons experience relatively little scattering.

6. An integrated circuit as claimed in claim 5, wherein the undoped channel is of GaAs composition.

7. An integrated circuit as claimed in claim 6, wherein the undoped channel (g) extends through the modulator and is relatively thin for low absorption in the modulator.

8. An integrated circuit as claimed in any preceding claim, wherein the electronic device (3) is a high electron mobility transistor.

9. An integrated circuit as claimed in any preceding claim, wherein the reflector (i) is of AlGaAs/AlAs composition.

10. An integrated circuit as claimed in any preceding claim, wherein the optical modulator (2) is of the vertically-propagating type.

11. A method of producing an optoelectronic integrated circuit comprising at least one optical modulator (2) of the p-MQWi-n type and at least one electronic device (3) in an integrated monolithic structure, the method comprising the steps of:-
growing an undoped reflector on a substrate;
growing optical modulator layers ((h)-(a)) above the reflector;
etching the optical modulator layers ((a)-(h)) at selected locations to expose the lower doped optical modulator layer closest to the substrate ((d)-(h)); and
fabricating an electronic device (3) in said lower doped optical modulator layer.

12. A method as claimed in claim 11, wherein the electronic device is fabricated in the n-layer ((d)-(h)) of the optical modulator.

13. A method as claimed in claims 11 to 12, wherein:-
the lower doped optical modulator layer is grown as a plurality of sub-layers; and
etching takes place to selectively expose some of said sub-layers to form the electronic device.

14. A method as claimed in claim 13, wherein said sub-layers comprise a plurality of lower sub-layers at least some of which are exposed, and an upper layer which is removed during etching.

15. A method as claimed in claims 13 or 14, wherein one of said sub-layers is undoped GaAs to form an undoped channel for the electronic device.

16. A method as claimed in claim 15, wherein the electronic device is of the high electron mobility type.

17. A method as claimed in any of claims 11 to 16 comprising the further step of increasing front surface reflectivity of the modulator by deposition of a higher reflectivity front mirror.

18. A method as claimed in any of claims 11 to 16 comprising the further step of applying an antireflection coating to the modulator front surface to destroy the optical cavity.

## Patentansprüche

1. Monolithische optoelektronische integrierte Schaltung (1), die folgendes umfaßt:
ein Substrat;
ein optisches Bauelement (2) in der Form einer pin-Mesastruktur; und
ein elektronisches Bauelement (3), das quer zu dem optischen Bauelement in der Richtung seiner pin-Schichten ((a)-(h)) angeordnet und in einer tieferen der dotierten Schichten hergestellt ist, die dem Substrat ((d)-(h)) des optischen Bauelementes am nächsten liegt, dadurch gekennzeichnet, daß:
das optische Bauelement (2) ein Modulator mit der i-Schicht in der Form einer MQW-Struktur ist; und
der optische Modulator (2) und das elektronische Bauelement (3) auf einem undotierten Reflektor (i) hergestellt sind, der wiederum auf dem Substrat hergestellt ist.

2. Integrierte Schaltung nach Anspruch 1, bei der eine tiefere dotierte optische Modulatorschicht, die dem Reflektor am nächsten liegt, eine Mehrzahl von Subschichten (d-h) umfaßt, wobei die genannten Subschichten eine Mehrzahl von tieferen Subsichten umfassen, die in dem optischen Modulator und dem elektronischen Bauelement vorhanden sind, und eine höhere Subschicht, die nur in dem optischen Modulator vorhanden ist.

3. Integrierte Schaltung nach einem der vorherigen Ansprüche, bei der das elektronische Bauelement in der n-Schicht ((d)-(h)) des optischen Modulators hergestellt ist.

4. Integrierte Schaltung nach einem der vorherigen Ansprüche, bei der das elektronische Bauelement ein Feldeffekttransistor ist.

5. Integrierte Schaltung nach einem der vorherigen Ansprüche, bei der das elektronische Bauelement einen undotierten Kanal (g) umfaßt, so daß Elektronen eine relativ geringe Streuung erfahren.

6. Integrierte Schaltung nach Anspruch 5, bei der der undotierte Kanal die Zusammensetzung GaAs aufweist.

7. Integrierte Schaltung nach Anspruch 6, bei der der undotierte Kanal (g) durch den Modulator verläuft und für eine geringe Absorption in dem Modulator relativ dünn ist.

8. Integrierte Schaltung nach einem der vorherigen Ansprüche, bei der das elektronische Bauelement (3) ein Transistor mit hoher Elektronenmobilität ist.

9. Integrierte Schaltung nach einem der vorherigen Ansprüche, bei der der Reflektor (i) die Zusammensetzung AlGaAs/AlAs hat.

10. Integrierte Schaltung nach einem der vorherigen Ansprüche, bei der der optische Modulator (2) vom Senkrechtausbreitungstyp ist.

11. Verfahren zur Herstellung einer optoelektronischen integrierten Schaltung, umfassend wenigstens einen optischen Modulator (2) des Typs p-MQWi-n und wenigstens ein elektronisches Bauelement (3) in einer integrierten, monolithischen Struktur, wobei das Verfahren die folgenden Schritte umfaßt:
Aufwachsenlassen eines undotierten Reflektors auf einem Substrat;
Aufwachsenlassen optischer Modulatorschichten ((h)-(a)) über dem Reflektor;
Ätzen der optischen Modulatorschichten ((a)-(h)) an ausgewählten Stellen, um die tiefere dotierte optische Modulatorschicht zu exponieren, die sich dem Substrat ((d)-(a)) am nächsten befindet; und
Herstellen eines elektronischen Bauelementes (3) in der genannten tieferen dotierten optischen Modulatorschicht.

12. Verfahren nach Anspruch 11, bei dem das elektronische Bauelement in der n-Schicht ((d)-(h)) des optischen Modulators hergestellt ist.

13. Verfahren nach den Ansprüchen 11 bis 12, bei dem:
die tiefere dotierte optische Modulatorschicht als eine Mehrzahl von Subschichten aufwachsen gelassen wird; und
geätzt wird, um einige der genannten Subschichten selektiv zu exponieren, um das elektronische Bauelement zu bilden.

14. Verfahren nach Anspruch 13, bei dem die genannten Subschichten eine Mehrzahl von tieferen Subschichten umfassen, von denen wenigstens einige exponiert sind, und eine obere Schicht, die während des Ätzens entfernt wird.

15. Verfahren nach Anspruch 13 oder 14, bei dem eine der genannten Subschichten undotiertes GaAs ist, um einen undotierten Kanal für das elektronische Bauelement zu bilden.

16. Verfahren nach Anspruch 15, bei dem das elektronische Bauelement vom Typ mit hoher Elektronenmobilität ist.

17. Verfahren nach einem der Ansprüche 11 bis 16, ferner umfassend den Schritt des Erhöhens des Reflexionsvermögens der Vorderseite des Modulators durch Auftragen eines Vorderspiegels mit höherem Reflexionsvermögen.

18. Verfahren nach einem der Ansprüche 11 bis 16, ferner umfassend den Schritt des Aufbringens einer Anti-Reflexionsbeschichtung auf die Vorderseite des Modulators, um den optischen Hohlraum zu zerstören.

## Revendications

1. Circuit intégré optoélectronique monolithique (1) comprenant :
un substrat ;
un dispositif optique (2) sous la forme d'une structure mésa PIN ; et
un dispositif électronique (3) monté transversalement au dispositif optique dans la direction de ses couches PIN ((a) - (h)), et fabriqué dans une couche inférieure des couches dopées la plus proche du substrat ((d) - (h)) du dispositif optique,
caractérisé en ce que :
le dispositif optique (2) est un modulateur avec la couche I sous la forme d'une structure MQW ; et
le modulateur optique (2) et le dispositif électronique (3) sont fabriqués sur un réflecteur non dopé (i) qui est lui-même fabriqué sur le substrat.

2. Circuit intégré selon la revendication 1, dans lequel une couche de modulateur optique dopée inférieure la plus proche du réflecteur comprend une pluralité de sous-couches (d - h), lesdites sous-couches comprenant une pluralité de sous-couches inférieures qui sont présentes aussi bien dans le modulateur optique que dans le dispositif électronique, et une sous-couche supérieure qui est présente seulement dans le modulateur optique.

3. Circuit intégré selon l'une quelconque des revendications précédentes, dans lequel le dispositif électronique est fabriqué dans la couche N ((d) - (h)) du modulateur optique.

4. Circuit intégré selon l'une quelconque des revendications précédentes, dans lequel le dispositif électronique est un transistor à effet de champ.

5. Circuit intégré selon l'une quelconque des revendications précédentes, dans lequel le dispositif électronique comprend un canal non dopé (g), de sorte que les électrons subissent relativement peu de diffusion.

6. Circuit intégré selon la revendication 5, dans lequel le canal non dopé est une composition de GaAs.

7. Circuit intégré selon la revendication 6, dans lequel le canal non dopé (g) s'étend à travers le modulateur et est relativement mince pour une faible absorption dans le modulateur.

8. Circuit intégré selon l'une quelconque des revendications précédentes, dans lequel le dispositif électronique (3) est un transistor à mobilité électronique élevée.

9. Circuit intégré selon l'une quelconque des revendications précédentes, dans lequel le réflecteur (i) est fait d'une composition AlGaAs/AlAs.

10. Circuit intégré selon l'une quelconque des revendications précédentes, dans lequel le modulateur optique (2) est du type à propagation verticale.

11. Procédé de fabrication d'un circuit intégré optoélectronique comprenant au moins un modulateur optique (2) du type P-MQWI-N et au moins un dispositif électronique (3) dans une structure monolithique intégrée, le procédé comprenant les étapes consistant à :
faire croître un réflecteur non dopé sur un substrat ;
faire croître des couches de modulateur optique ((h) - (a)) sur le réflecteur ;
attaquer chimiquement les couches de modulateur optique ((a) - (h)) à des emplacements choisis pour exposer la couche de modulateur optique dopée inférieure la plus proche du substrat ((d) - (h)) ; et
fabriquer un dispositif électronique (3) dans ladite couche de modulateur optique dopée inférieure.

12. Procédé selon la revendication 11, dans lequel le dispositif électronique est fabriqué dans la couche N ((d) - (h)) du modulateur optique.

13. Procédé selon les revendications 11 à 12, dans lequel :
on fait croître la couche de modulateur optique dopée inférieure sous forme d'une pluralité de sous-couches ; et
l'attaque chimique est mise en oeuvre pour exposer sélectivement certaines desdites sous-couches afin de former le dispositif électronique.

14. Procédé selon la revendication 13, dans lequel lesdites sous-couches comprennent une pluralité de sous-couches inférieures dont au moins certaines sont exposées, et une couche supérieure qui est retirée pendant l'attaque chimique.

15. Procédé selon les revendications 13 ou 14, dans lequel une desdites sous-couches est en GaAs non dopé pour former un canal non dopé pour le dispositif électronique.

16. Procédé selon la revendication 15, dans lequel le dispositif électronique est du type à mobilité électronique élevée.

17. Procédé selon l'une quelconque des revendications 11 à 16, comprenant l'étape supplémentaire consistant à augmenter la réflexivité de la surface avant du modulateur en déposant un miroir avant de réflexivité plus élevée.

18. Procédé selon l'une quelconque des revendications 11 à 16, comprenant l'étape supplémentaire consistant à appliquer un revêtement anti-réfléchissant sur la surface avant du modulateur pour supprimer la cavité optique.
